# FASCICULE DE BREVET EUROPEEN

(11) **EP 0 436 992 B1**
(45) Date de publication et mention de la délivrance du brevet: **18.05.1994**
(21) Numéro de dépôt: 90203441.2
(22) Date de dépôt: 19.12.1990
(51) Int. Cl.: H05K 13/00

(54) **Dispositif de positionnement pour la fabrication de circuits imprimés**
Positionierungsvorrichtung für die Herstellung von gedruckten Leiterplatten
Positioning device for printed circuit board manufacture

(30) Priorité: 12.01.1990 FR 9000333
(43) Date de publication de la demande: 17.07.1991
(73) Titulaire: PHILIPS CIRCUITS IMPRIMES, 27016 Evreux (FR); Philips Electronics N.V., 5621 BA Eindhoven (NL)
(72) Inventeur: Sorel, Alain, F-75008 Paris (FR)
(74) Mandataire: Caron, Jean

(56) Documents cités:
- FR-A- 2 077 313
- US-A- 4 226 526
- IBM TECHNICAL DISCLOSURE BULLETIN. vol. 30, no. 5, octobre 1987, NEW YORK US pages 228 - 229; "Air Bearing Module Alignment"

## Description

La présente invention concerne un dispositif de positionnement de circuits imprimés, constitué d'un plateau support sur laquelle est créé un coussin d'air pour soutenir un circuit imprimé qui peut être déplacé sur ce coussin d'air, le plateau étant aussi muni de butées de positionnement pour arrêter le circuit imprimé dans une position déterminée.

Un tel dispositif est utilisé dans une ligne de fabrication de circuits imprimés pour obtenir le positionnement précis qui est nécessité pour certaines opérations, comme par exemple pour l'insolation des circuits recouverts d'un vernis photosensible ou bien aussi pour leur perçage.

Le document US-4 226 526 (Spence-Bate et al) décrit un dispositif correspondant au préambule ci-dessus. Il utilise, pour que les pièces soient poussées contre les butées, un flux d'air orienté qui dirige le circuit vers celles-ci, et les moyens de travail des circuits sont situés sur la machine elle-même. On a constaté qu'un tel flux orienté est d'un emploi délicat, car son effet est différent selon le poids des pièces à mouvoir (qui varie dans des proportions importantes avec l'épaisseur du circuit imprimé), et il peut aussi présenter des difficultés si les circuits imprimés sont un peu gondolés, car l'action du flux d'air est alors inégale.

Afin de résoudre ces difficultés, on ne cherche pas à déplacer le circuit au moyen de jets d'air orientés, et le dispositif selon l'invention est muni, pour le déplacement du circuit imprimé vers les butées de positionnement, de moyens de basculement du plateau support et de moyens pour commander à volonté ledit basculement.

Il est malaisé de concevoir une machine (par exemple une machine d'insolation ou de perçage) dont le plateau soit inclinable, c'est pourquoi le dispositif n'est pas inclus dans une telle machine mais constitue une station autonome dans une ligne de fabrication. Il est alors avantageusement muni de moyens pour supprimer le coussin d'air et pour le remplacer par une aspiration afin d'appliquer le circuit imprimé sur le plateau. Ainsi le positionnement obtenu par appui sur les butées sous l'effet de la gravité peut être maintenu et le dispositif est associé à un dispositif de manutention pour emmener le circuit imprimé vers une station d'insolation ou de perçage sans dégrader le positionnement réalisé.

Pour utiliser au mieux les potentialités du dispositif, ce dernier est avantageusement muni d'un automate qui sucessivement installe le coussin d'air et fait basculer le plateau, puis après un délai commande l'application de l'aspiration puis la mise à l'horizontale du plateau.

Le dispositif est muni d'une première butée ou famille de butées de positionnement et d'une seconde butée ou famille de butées de positionnement correspondant chacune à une direction de butée, les deux directions de butée étant perpendiculaires entre elles, et le basculement s'effectue sur un pivot dont l'axe est placé en diagonale par rapport à ces deux directions. Ainsi le positionnement est obtenu simultanément dans deux directions en une seule opération.

La description qui va suivre, en regard des dessins annexés décrivant des exemples non limitatifs fera bien comprendre comment l'invention peut être réalisée.

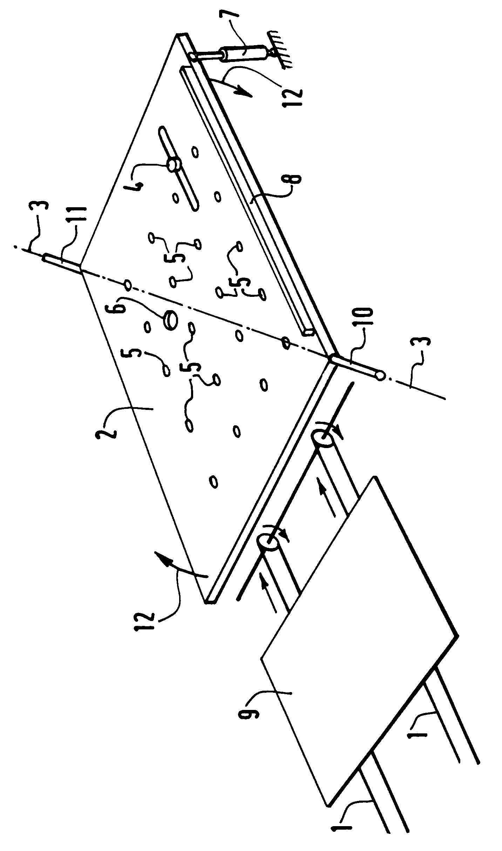

La figure unique représente en perspective le dispositif de l'invention.

Un tel dispositif peut être installé par exemple dans une ligne de fabrication de circuits imprimés juste en amont d'un dispositif d'insolation de vernis photosensible, dispositif dans lequel une grande précision de positionnement est requise.

Les plaques de circuits imprimés 9 en cours de fabrication sont amenées par un tapis roulant constitué au moyen de courroies transporteuses représentées schématiquement en 1. Tant qu'une partie d'une plaque est encore sur le tapis roulant, elle est poussée vers la droite sur la figure et finit par se trouver au moins dans sa plus grande partie sur le plateau 2 du dispositif.

Ce plateau 2 est muni d'orifices 5 par lesquels de l'air peut être soufflé de façon à créer un coussin d'air sous la plaque de circuit imprimé (qui est représentée sur le tapis roulant mais pas sur le plateau du dispositif, afin d'en dégager la vue).

Le plateau 2 est muni de deux butées de positionnement 4 et 8 correspondant à deux directions de butée perpendiculaires entre elles.

Une première butée est la butée 4 vers laquelle la plaque est poussée par le tapis roulant 1. Pendant l'utilisation du dispositif, la position de cette butée par rapport au plateau est fixe, mais elle peut être réglée à l'avance selon la dimension et la forme des plaques de circuit imprimé (ce réglage peut même être éxécuté sans intervention d'un opérateur par un automate qui a en mémoire les caractéristiques du circuit imprimé à traiter). Il pourrait aussi y avoir plusieurs butées placées le long d'une perpendiculaire à la direction d'amenée du circuit et commandées ensemble.

La deuxième butée est la butée 8, placée latéralement par rapport au mouvement d'amenée de la plaque par le tapis roulant, et qui est fixe. Il s'agit ici d'une butée continue le long du bord du plateau mais on pourrait aussi bien imaginer une famille de butées ponctuelles.

Le plateau 2 est muni de pivots 10, 11 autour desquels il peut basculer et dont l'axe 3 est placé en diagonale par rapport aux deux directions de butée. Un vérin 7 placé en un point distant de l'axe 3 est fixé d'un coté au plateau et de l'autre en un point fixe et permet de faire basculer le plateau 2 comme indiqué par les flèches 12 et aussi de le replacer en position horizontale.

Lorsque la plaque est sortie du tapis roulant, et entièrement ou presque entièrement passée sur le plateau 2, ce dernier est basculé (ceci étant obtenu dans le cas représenté par la figure au moyen d'un raccourcissement du vérin 7), ce qui a pour effet que le circuit imprimé soulevé par le coussin d'air descend par gravité vers les butées 4 (en avant) et 8 (latéralement). L'angle d'inclinaison peut être raisonablement compris entre 15° et 30°. Il pourrait bien entendu être plus grand mais cela compliquerait inutilement les moyens de réalisation du basculement.

Une fois le circuit appuyé contre les butées 4 et 8, le soufflage d'air est supprimé et remplacé par une aspiration : ainsi le circuit est fermement appliqué sur le plateau 2, qui est ensuite relevé en position horizontale, où le circuit est alors pris par l'organe de saisie d'un dispositif de manutention, ce qui permet alors de supprimer l'aspiration de façon à permettre l'enlèvement du circuit par ledit dispositif de manutention. Celui-ci réalise un mouvement de montée suivi d'une translation horizontale vers une machine qui suit le présent dispositif. L'organe de saisie en question peut être constitué par exemple selon la description de la demande de brevet FR-A-89 0669 à publier en juillet 1990.

Pour commander ces différentes opérations, le dispositif est muni d'un automate. Un organe 6 senseur de la présence d'un circuit (par exemple une cellule photoélectrique) informe l'automate pour le déclenchement de la séquence d'opérations de positionnement. Le vérin 7 est par exemple un vérin pneumatique commandé par une électrovanne, elle même commandée par l'automate. Pour l'établissement du coussin d'air ou celui de l'aspiration, les orifices 5 sont reliés soit à une canalisation de vide, soit à une canalisation d'air comprimé, au moyen d'un ensemble d'électrovannes commandées par l'automate.

Ainsi l'automate peut installer sucessivement le coussin d'air et faire basculer le plateau, puis après un délai commander l'application de l'aspiration puis la mise à l'horizontale du plateau.

Si l'automate a en mémoire les caractéristiques du type de circuit imprimé en cours de traitement, le dispositif est avantageusement muni de moyens commandables par cet automate pour régler la force du coussin d'air selon le poids du circuit imprimé, et l'automate choisit quelle force est appliquée. A cet effet un groupe de plusieurs éléments en parallèle constitués chacun d'une électrovanne en série avec un tandem détendeur-limiteur de débit (chacun avec une valeur de réglage différente) est installé en série dans la canalisation d'air comprimé, et l'automate choisit lequel d'entre eux est mis en service, en ouvrant l'électrovanne correspondante. On peut prévoir par exemple un groupe de quatre éléments de ce genre, ce qui procure quatre valeurs pour la force du coussin d'air. Il est aussi possible de prévoir un élément détendeur-limiteur de débit réglable en continu, mais cela coûte plus cher.

## Revendications

1. Dispositif de positionnement de circuits imprimés, constitué d'un plateau support sur lequel est créé un coussin d'air pour soutenir un circuit imprimé qui peut être déplacé sur ce coussin d'air, le plateau étant aussi muni d'une butée ou d'un jeu de butées de positionnement pour arrêter le circuit imprimé dans une position déterminée, caractérisé en ce que, pour le déplacement du circuit imprimé vers la butée ou les butées de positionnement, il est muni de moyens de basculement du plateau support et de moyens pour commander à volonté ledit basculement.

2. Dispositif selon la revendication 1, caractérisé en ce qu'il est muni de moyens pour supprimer le coussin d'air et pour le remplacer par une aspiration afin d'appliquer le circuit imprimé sur le plateau.

3. Dispositif selon la revendication 2, caractérisé en ce que, le dispositif étant situé dans une ligne de fabrication, il est associé à un dispositif de manutention pour emmener le circuit imprimé vers une station de travail distincte.

4. Dispositif selon l'une des revendications 2 ou 3, caractérisé en ce qu'il est muni d'un automate qui sucessivement installe le coussin d'air et fait basculer le plateau, puis après un délai commande l'application de l'aspiration puis la mise à l'horizontale du plateau.

5. Dispositif selon la revendication 4, caractérisé en ce qu'il est muni de moyens commandables par l'automate pour régler la force du coussin d'air selon le poids du circuit imprimé, et l'automate choisit quelle force est appliquée.

6. Dispositif selon l'une quelconque des revendications précédentes, caractérisé en ce qu'il est muni d'une première butée ou famille de butées de positionnement et d'une seconde butée ou famille de butées de positionnement correspondant chacune à une direction de butée, les deux directions de butée étant perpendiculaires entre elles, et en ce que le basculement s'effectue sur un pivot dont l'axe est placé en diagonale par rapport à ces deux directions.

7. Dispositif selon la revendication 6, caractérisé en ce qu'il est muni de butées fixes dans une direction et de butées réglables dans l'autre direction.

8. Dispositif selon l'une quelconque des revendications précédentes, caractérisé en ce que, le dispositif étant situé dans une ligne de fabrication, il est précédé par un dispositif d'amenée des circuits imprimés à tapis roulant.

## Claims

1. A positioning device for printed circuits, formed by a support plate on which an air cushion is created for supporting a printed circuit which can be displaced on this air cushion, the plate also being provided with positioning stops for holding the printed circuit in a given position, characterized in that the device is provided with means for tilting the support plate in order to achieve the displacement of the printed circuit towards the positioning stops, and with means for controlling this tilting movement at will.

2. A device as claimed in Claim 1, characterized in that it is provided with means for eliminating the air cushion and replacing it with a vacuum so as to press the printed circuit against the support plate.

3. A device as claimed in Claim 2, characterized in that, the device being included in a production line, it is associated with a handling device for moving the printed circuit board towards a separate work station.

4. A device as claimed in one of the Claims 2 and 3, characterized in that the device is provided with a automatic unit which in that order generates the air cushion ad causes the support plate to tilt, and subsequently after a delay triggers the application of the vacuum followed by a horizontal positioning of the support plate.

5. A device as claimed in Claim 4, characterized in that it is provided with means controllable by said automatic unit for adjusting the force of the air cushion in dependence on the weight of the printed circuit, the automatic unit selecting the force to be applied.

6. A device as claimed in any one of the preceding Claims, characterized in that the device is provided with a first positioning stop or group of positioning stops and with a second positioning stop or group of positioning stops, each corresponding to one abutment direction, the two abutment directions being mutually perpendicular, and in that the tilting is carried out over a pivot axis which is diagonal relative to these two directions.

7. A device as claimed in Claim 6, characterized in that it is provided with fixed stops in one direction and with adjustable stops in the other direction.

8. A device as claimed in any one of the preceding Claims, characterized in that, the device being included in a production line, it is preceded by a device for feeding printed circuit boards by means of a conveyor belt.

## Patentansprüche

1. Positioniervorrichtung für Leiterplatten, die aus einer Trägerplatte besteht, auf der ein Luftkissen zum Unterstützen einer Leiterplatte geschaffen ist, die auf dem Luftkissen verlagerbar ist, wobei die Trägerplatte außerdem mit einem Positionieranschlag oder mit einer Reihe von Positionieranschlägen versehen ist, um die Leiterplatte in einer bestimmten Stellung am Platz zu halten, dadurch gekennzeichnet, daß die Vorrichtung für die Verlagerung der Leiterplatte nach den Positionieranschlägen mit Kippmitteln der Trägerplatte und mit Mitteln zum beliebigen Steuern dieses Kippvorgags versehen ist.

2. Vorrichtung nach Anspruch 1, dadurch gekennzeichnet, daß sie mit Mitteln zum Ausschalten des Luftkissens und zum Ersetzen des Luftkissens durch eine Aspiration zum Anbringen der Leiterplatte auf der Trägerplatte versehen.

3. Vorrichtung nach Anspruch 2, dadurch gekennzeichnet, daß sie in eine Fertigungsstraße aufgenommen und einer Transportvorrichtung zum Befördern der Leiterplatte nach einer eindeutigen Arbeitsstation zugeordfnet ist.

4. Vorrichtung nach Anspruch 2 oder 3, dadurch gekennzeichnet, daß sie mit einem Automaten versehen ist, der aufeinaderfolgend das Luftkissen erzeugt und die Trägerplatte kippt, danach mit einer Verzögerung das Einschalten der Aspiration und anschließend das Horizontalstellen der Trägerplatte steuert.

5. Vorrichtung nach Anspruch 4, dadurch gekennzeichnet, daß sie mit vom Automaten steuerbaren Mitteln zum Einstellen der Kraft des Luftkissens anhand des Gewichts der Leiterplatte versehen ist, und der Automat die anzuwendende Kraft wählt.

6. Vorrichtung nach einem oder mehreren der vorangehenden Ansprüche, dadurch gekennzeichnet, daß sie mit einem ersten Positionieranschlag oder mit einer ersten Reihe von Positionieranschlägen sowie mit einem zweiten Positionieranschlag oder mit einer zweiten Reihe von Positionieranschlägen entsprechend je einer Anschlagsrichtung versehen ist, wobei die zwei Anschlagsrichtungen einander gegenüberliegen, und daß die Kippbewegung um einen Zapfen erfolgt, dessen Achse in bezug auf diese zwei Richtungen diagonal verläuft.

7. Vorrichtung nach Anspruch 6, dadurch gekennzeichnet, daß sie in einer Richtung mit festen Anschlägen und in der anderen Richtung mit einstellbaren Anschlägen versehen ist.

8. Vorrichtung nach einem oder mehreren der vorangehenden Ansprüche, dadurch gekennzeichnet, daß die Vorrichtung sich in einer Fertigungsstraße befindet, der eine Transportvorrichtung für Leiterplatten auf einem Fließbad vorgeschaltet ist.
